## Europäisches Patentamt
## European Patent Office
## Office européen des brevets

(19)

(11) Numéro de publication: **0 201 136**
**B1**

(12) **FASCICULE DE BREVET EUROPEEN**

(45) Date de publication du fascicule du brevet: **19.12.90**

(51) Int. Cl.⁵: **H 03 K 17/62**

(21) Numéro de dépôt: **86200781.2**

(22) Date de dépôt: **05.05.86**

(54) **Module multiplexeur numérique à N entrées et multiplexeur à N2 entrées incorporant de tels modules.**

(30) Priorité: **10.05.85 FR 8507122**

(43) Date de publication de la demande:
**12.11.86 Bulletin 86/46**

(45) Mention de la délivrance du brevet:
**19.12.90 Bulletin 90/51**

(84) Etats contractants désignés:
**DE FR GB IT NL**

(56) Documents cités:
**EP-A-0 086 434**  **US-A-4 112 314**
**JP-A-55 118 228**  **US-A-4 145 623**

**IBM TECHNICAL DISCLOSURE BULLETIN, vol. 26, no. 8, janvier 1984, page 4067, 4068, IBM Corp., New York, US; J.P. PANTANI et al.: "Low power N-way analog multiplexer"**

**REVIEW OF THE ELECTRICAL COMMUNICATION LABORATORIES, vol. 26, no. 9/10, septembre/octobre 1978, pages 1325-1338, Tokyo, JP; H. MUKAI et al.: "Master slice ECL LSI"**

(73) Titulaire: **PHILIPS COMPOSANTS**
**117, quai du Président Roosevelt**
**F-92130 Issy les Moulineaux (FR)**
(84) **FR**

(73) Titulaire: **N.V. Philips' Gloeilampenfabrieken**
**Groenewoudseweg 1**
**NL-5621 BA Eindhoven (NL)**
(84) **DE GB IT NL**

(72) Inventeur: **Moussie, Michel**
**Société Civile S.P.I.D. 209, rue de l'Université**
**F-75007 Paris (FR)**

(74) Mandataire: **Jacquard, Philippe et al.**
**Société Civile S.P.I.D. 156, Boulevard Haussmann**
**F-75008 Paris (FR)**

(56) Documents cités:
**ELECTRONIC LETTERS, vol. 20, no. 13, juin 1984, pages 546-548, Staines, Middlesex, GB; H.M. REIN et al.: "Integrated bipolar 4:1 time-division multiplexer for bit rates up to 3Gbit/s"**

Courier Press, Leamington Spa, England.

EP 0 201 136 B1

## Description

La présente invention concerne un module multiplexeur numérique à N entrées, chaque entrée est susceptible d'être portée à un niveau haut ou à un niveau bas étant constituée par la base d'une transistor d'entrée d'un premier groupe dont le collecteur est connecté à une première source de tension d'alimentation et dont l'émetteur est couplé à une électrode d'un premiere type d'un premier élément semiconducteur de sortie présentant une pluralité d'électrodes du premier type ainsi qu'une électrode d'un deuxième type, qui constitue la sortie du module et qui est reliée à ladite première source de tension d'alimentation par l'intermédiaire d'une première résistance de sortie, ledit module présentant également un premier circuit logique d'adressage présentant une pluralité d'entrées et destiné à adresser l'un ou l'autre des transistors d'entrée du premier groupe en aiguillant une première source de courant référencée par rapport à un deuxième source de tension d'alimentation vers l'un ou l'autre des émetteurs des transistors d'entrée du premier groupe en fonction de l'adresse qu'il reçoit.

Un tel multiplexeur est connu de la demande de brevet japonais JP—A—55-118229 intitulée "Multiplexer circuit".

Dans cette antériorité, N=3 et ledit élément semi-conducteur de sortie est un transistor multi-émetteurs, dont les émetteurs constituent les électrodes d'actionnement et qui reçoit sur sa base une tension de référence et dont le collecteur, qui est l'électrode de sortie du multiplexeur, est relié à la masse à travers une résistance de valeur bien déterminée.

Lorsque plusieurs multiplexeurs de ce type sont utilisées dans un même circuit, la même source de tension de référence alimente les bases des transistors multi-émetteurs de sortie et la Demanderesse a constaté qu'il en résultait des couplages parasites entre les sorties des multiplexeurs.

L'invention a pour objet un module multiplexeur dont l'étage de sortie ne présente pas de tension de référence, ce qui apporte l'avantage d'une plus grande simplicité intrinsèque et permet d'éviter l'inconvénient précité lorsque le module est associée à d'autres modules.

Le module multiplexeur selon l'invention est dans ce but caractérisé en ce que le premier élément semi-conducteur de sortie présente une pluralité de diodes dont une électrode est commune et constitue l'électrode de sortie, et dont l'autre électrode constitue chacune une des électrodes d'actionnement, et en ce que la première résistance de sortie a une valeur telle que lorsque la base du transistor d'entrée adressé est au niveau bas le courant de la première source de courant se répartisse de manière sensiblement égale entre l'émetteur dudit transistor d'entrée adressé et l'électrode d'actionnement qui lui est couplée.

De préférence, le premier élément semi-conducteur de sortie est un premier transistor de sortie multi-émetteurs dont la base et le collecteur sont reliés et constituent l'électrode du deuxième type et dont les émetteurs constituent les électrodes du premier type.

Ainsi qu'il sera expliqué dans la suite de la description, un des niveaux logiques en sortie du module est légèrement décalé par rapport au niveau normalisé. De ce fait, un tel module est de préférence utilisé pour attaquer un étage situé sur le même circuit intégré ou hybride, c'est-à-dire avec une liaison électrique courte.

Le module multiplexeur selon l'invention présente en outre un avantage important. Du fait que, comme il sera montré dans la suite de la description, le premier élément semi-conducteur de sortie est toujours traversé par un courant, si faible soit-il, le module selon l'invention est notablement plus rapide que celui de l'art antérieur.

Selon un mode de réalisation, le module présente $N=2^n$ entrées pour lesquelles le première circuit logique d'adressage comporte n étages différentiels en cascade, le $k^{ème}$ étage présentant $2^{k-1}$ paires différentielles comportant chacune deux transistors à émetteurs couplés dont un reçoit sur sa base une $k^{ème}$ tension de référence d'adressage et dont l'autre reçoit sur sa base un niveau logique d'adresse de l'étage, les collecteurs des transistors des paires différentielles des $(n-1)$ premiers étages étant reliés au point commun des émetteurs d'une paire différentielle de l'étage de rand immédiatement supérieur, et ceux des transistors du $n^{ième}$ étage étant reliés chacun à un émetteur d'un transistor d'entrée.

La source de tension d'alimentation peut être, de manière connue en soi au potentiel de la masse et les tensions de référence d'adressage, négatives.

L'invention concerne également un multiplexeur numérique à $N^2$ entrées associant N modules multiplexeur , d'entrée à N entrées tels que définis ci-dessus à un module multiplexeur de sortie à N entrées dont chacune reçoit une sortie d'un des modules d'entrée.

Selon une première variante, le module multiplexeur de sortie est également du type défini ci-dessus, de telle sorte que le multiplexeur ne comporte pas de tension de référence sur son transistor de sortie.

Selon une variante préférée, le module multiplexeur de sortie est d'un type selon l'art antérieur, de telle sorte que seul le module multiplexeur de sortie présentant une tension de référence sur son transistor de sortie, le multiplexeur délivre en sortie des signaux de niveau normalisé tout en restant exempt de couplages parasites.

Ce module multiplexeur de sortie peut présenter un circuit d'adressage de même type que les autres modules du multiplexeur. Les sources de courant aiguillées par les circuits d'adressage des modules d'entrée et du module de sortie peuvent présenter la même intensité et dans ce cas la première résistance de sortie des modules multiplexeurs d'entrée ont une valeur double de celle de la deuxième résistance de sortie, c'est-à-dire celle du module multiplexeur de sortie.

Selon un mode de réalisation particulièrement avantageux de la deuxième variante, les collecteurs des transistors d'entrée du module multiplexeur de sortie sont connectés entre eux et reliés à la source de tension d'alimentation par l'intermédiaire d'une troisième résistance de sortie de même valeur que la deuxième résistance de sortie, de telle sorte que le signal présent sur les collecteurs des transistors d'entrée du deuxième groupe constitue une sortie logique inversée du multiplexeur.

Selon un deuxième mode de réalisation de la deuxième variante, le multiplexeur comporte un circuit d'aiguillage commandé par un signal logique de mémorisation présentant un premier et un deuxième état, et dirigeant la deuxième source de courant dans le premier état vers le deuxième circuit logique d'adressage (fonction multiplexage), et dans le deuxième état vers un transistor d'auto entretien, dont l'émetteur est connecté à un $N+1^{ième}$ émetteur du deuxième transistor de sortie dont la base est connectée au collecteur de ce dernier et dont le collecteur est connecté à ladite source de tension d'alimentation, le transistor d'auto entretien assurant dans le deuxième état un auto-entretien au niveau du collecteur du deuxième transistor de sortie (fonction mémoire).

L'invention sera mieux comprise à la lecture de la description qui va suivre donnée à titre d'exemple, en liaison avec les figures qui représentent:

la figure 1, un module multiplexeur à quatre entrées selon l'art antérieur;

la figure 2a, un module multiplexeur à quatre entrées selon l'invention et la figure 2b un montage équivalent,

la figure 3, un schéma illustrant le fonctionnement du module multiplexeur des figures 2a et 2b;

la figure 4, un multiplexeur à seize entrées selon l'invention, associant cinq modules multiplexeurs;

la figure 5, un mode de réalisation du module multiplexeur de la figure 2;

la figure 6 un mode de réalisation du module multiplexeur de la figure 4 présentant une sortie et une sortie inverseuse;

et la figure 7, un mode de réalisation du module multiplexeur de la figure 4 présentant une fonction mémoire.

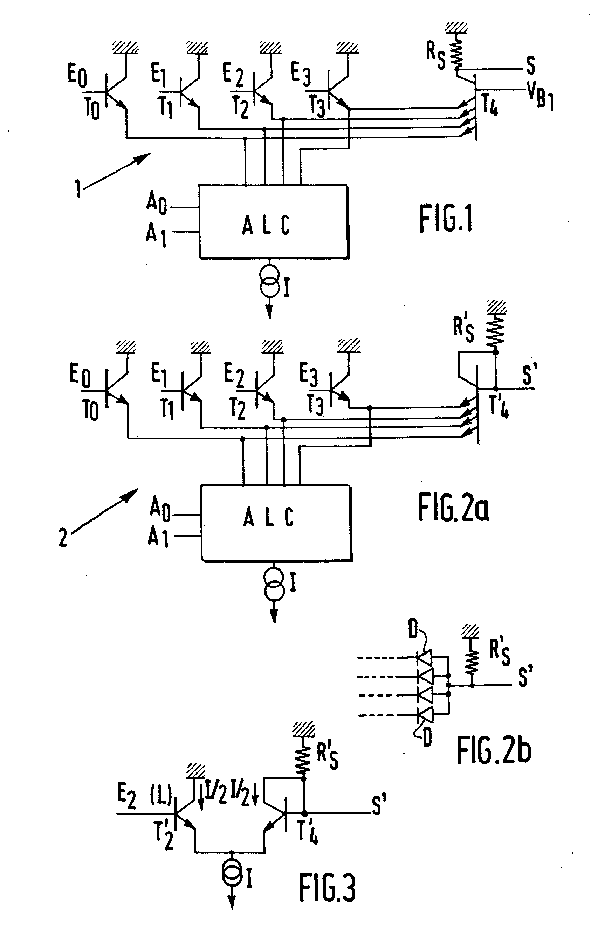

Un multiplexeur 1 à quatre entrées de l'art antérieur, représenté à la figure 1, comporte quatre transistors d'entrée $T_0$ à $T_3$ dont la base reçoit des signaux logiques d'entrée respectivement $E_0$ à $E_3$, dont le collecteur est connecté à la masse et dont l'émetteur est connecté à un émetteur d'un transistor multi-émetteurs de sortie $T_4$. Ce dernier reçoit sur sa base une tension de référence $V_{B1}$ et son collecteur, qui délivre le signal de sortie S du multiplexeur, est relié à la masse à travers une résistance de sortie $R_s$.

Un circuit logique d'adressage ALC reçoit deux signaux logiques d'adresses $A_0$ et $A_1$ qui définissent quatre états logiques pour chacun desquels la source de courant I, référencée comme il est d'usage courant à une source de tension $V_{EE}$, est aiguillée vers un émetteur des transistors d'entrée $T_0$ à $T_3$, ce qui permet de sélectionner tour à tour une des entrées respectivement $E_0$ à $E_3$. Si on considère que chacune des entrées peut se trouver soit à un niveau haut H normalisé de 0V, soit à un niveau bas L normalisé de −450 mV, avec $V_{B1}$=−225 mV et $R_s$I= 450 mV (en valeur absolue), le niveau de l'entrée sélectionnée, par exemple $E_2$, se retrouve à la sortie S. En effet, si $E_2$ est au niveau haut H (0 volt), tout le courant I passe dans le transistor $T_2$ et S=0 volt. Si $E_2$ est au niveau bas L (−450 mV), tout le courant I passe dans le transistor $T_4$ à travers celui de ses émetteurs qui est couplé à celui de $T_2$.

Le module multiplexeur 2 selon l'invention représenté à la figure 2a, comporte des éléments communs avec celui de l'art antérieur représenté à la figure 1: les transistors $T_0$ à $T_3$ recevant chacun sur sa base les entrées respectivement $E_0$ à $E_3$, le circuit logique d'adressage ALC avec ses signaux logiques d'adresses $A_0$ et $A_1$, ainsi que la source de courant I ainsi aiguillée vers le transistor correspondant à l'entrée sélectionnée.

La connexion du transistor de sortie est par contre modifiée. Il s'agit comme précédemment d'un transistor multi-émetteurs, maintenant référencé $T'_4$, dont les émetteurs sont couplés à ceux des transistors $T_0$ à $T_3$, mais dont la base et le collecteur sont court-circuités entre eux et forment la sortie S' du module et sont reliés à la masse par l'intermédiaire d'une résistance de sortie $R'_s$.

On suppose, comme dans le cas précédent, que l'entrée sélectionnée est $E_2$. Si $E_2$ est au niveau haut H (0 volt), le courant I passe en quasi-totalité (à 90% environ) dans le transistor $T'_2$ et la sortie S' du module est à un niveau légèrement négatif, en pratique de l'ordre de −80 mV. Si $E_2$ est au niveau bas L (−450 mV) (voir le schéma équivalent de la figure 3), et si on a $R'_s$I=900 mV (en valeur absolue), le courant I se répartit également (I/2) entre les transistors $T'_2$ et $T'_4$ si ceux-ci ont des émetteurs de même géométrie. Si on compare un module 2 selon l'invention à un multiplexeur 1 selon l'art antérieur pourvu d'une source de courant I de même intensité, il faut: $R'_s$=$2R_s$, pour obtenir un niveau bas B' de −450 mV à la sortie S'.

Comme il a été démontré ci-dessus, la sortie S' du module multiplexeur selon l'invention n'est pas directement utilisable comme sortie normalisée accessible de l'extérieur du circuit où se trouve le module du fait que son niveau haut H' est décalé par rapport au potentiel de la masse. Par contre, il est plus proche du niveau bas B' que dans l'art antérieur. D'autre part, le transistor de sortie $T'_4$ est toujours si peu que ce soit conducteur ce qui fait que le module selon l'invention est nettement plus rapide que dans l'art antérieur.

La sortie S' peut être utilisée pour attaquer un étage logique situé sur le même circuit, c'est-à-dire avec une liaison électrique courte.

Le transistor $T'_4$ de la figure 2a est équivalent électriquement à quatre diodes D, dont l'anode est commune et reliée à la sortie S' (borne non à la masse de la résistance R'$_s$) et sont les cathodes sont reliées respectivement aux émetteurs des transistors T$_0$ à T$_3$. En pratique, le montage de la figure 2a est plus rapide et c'est celui qui sera de ce fait utilisé. Un autre montage équivalent est constitué par quatre transistors dont les bases et les collecteurs sont connectés ensemble.

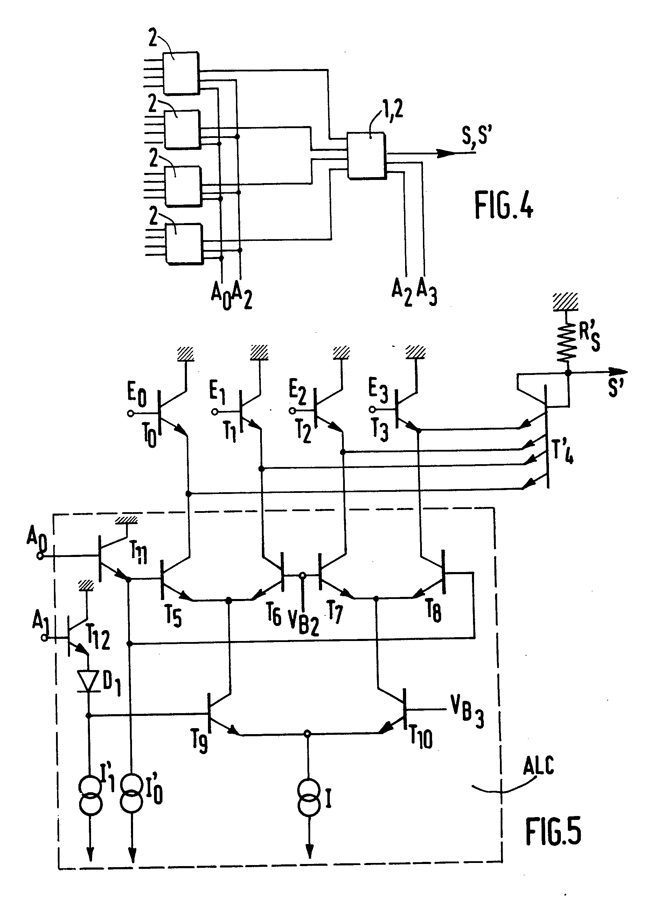

La figure 4 représente ainsi un multiplexeur à 16 voies comportant quatre modules d'entrée 2 selon l'invention dont chacun reçoit les signaux logiques d'adresses A$_0$ et A$_1$ et dont la sortie attaque soit (première variante) un module de sortie 2 selon l'invention (fig. 2) recevant deux signaux logiques d'adresse A$_2$ et A$_3$ pour produire un signal de sortie S' utilisable seulement pour attaquer un étage logique situé sur le même circuit, soit (variante préférée) un module de sortie 1 selon l'art antérieur (fig. 1) recevant deux signaux logiques d'addresse A$_2$ et A$_3$ pour produire un signal de sortie normalisé S qui peut être utilisé en dehors du circuit où se trouve le multiplexeur. Dans la variante préférée, seul le module de sortie 1 présente une transistor de sortie recevant une tension de référence propre, ce qui évite tout couplage parasite entre les sorties des modules d'entrée. En d'autres termes, on obtient un multiplexeur à 16 voies présentant les mêmes entrées et les mêmes sorties qu'un multiplexeur qui aurait été équipé de modules multiplexeurs d'entrée 1 de l'art antérieur, mais ne présentant pas lesdits couplages parasites.

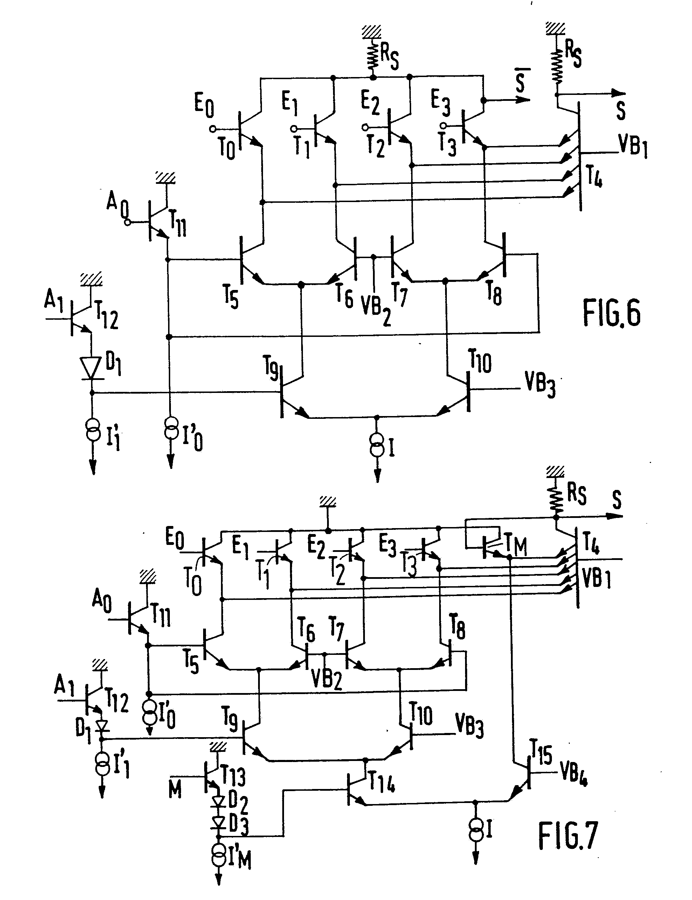

La figure 5 illustre un mode de réalisation du circuit logique d'adressage ALC, dans un module multiplexeur 2 selon la figure 2. Le signal logique A$_0$ attaque la base d'un transistor T$_{11}$ monté en émetteur suiveur et dont le collecteur est à la masse, de manière à décaler le signal A$_0$ de −0,8 V environ (valeur correspondant à la tension V$_{BE}$ d'un transistor) pour qu'il puisse attaquer un étage de deux cellules comportant chacune deux transistors (T$_5$, T$_6$) et (T$_7$, T$_8$) couplés par leurs émetteurs.

L'émetteur de T$_{11}$ attaque la base de T$_5$ et de T$_8$ et est chargé par une source de courant I$_0$', alors que la base de T$_6$ et de T$_7$ reçoivent une tension de référence V'$_{B2}$ égale à −1 V environ, valeur dont le niveau de A$_0$ a été décalé par le transistor T$_{11}$ (V$_{BE}$=−0,8 V) à laquelle s'ajoute la moitié de l'écart entre le niveau bas et le niveau haut (−0,225 mV).

Le collecteur des transistors T$_5$ à T$_8$ sont connectés aux émetteurs respectivement de T$_0$ à T$_3$.

Le signal logique d'adresse A$_1$ attaque la base d'un transistor T$_{12}$ monté en émetteur suiveur et dont le collecteur est à la masse. L'émetteur de transistor T$_{12}$ attaque une diode D$_1$ de manière à décaler le signal A$_1$ de −1,6 V environ (valeur correspondant à la tension V$_{BE}$ d'un transistor, à laquelle s'ajoute la tension d'une diode). La cathode de la diode D$_1$, chargée par une source de courant I'$_1$ attaque la base d'un transistor T$_9$ couplé par l'émetteur à un transistor T$_{10}$ dont la base reçoit une tension de référence V'$_{B3}$ égale à −1,8 V environ, en tenant compte du décalage (−1,6 V) du niveau du signal A$_1$ par T$_{12}$ et D$_1$. Les

émetteurs de T$_9$ et T$_{10}$ sont chargés par la source de courant I à aiguiller, alors que le collecteur de T$_9$ est reliée aux émetteurs de T$_5$ et T$_6$ et celui de T$_{10}$ aux émetteurs de T$_7$ et T$_8$. Pour sélectionner le transistor T$_2$ choisi dans l'exemple précédent, il faut afficher l'adresse A$_0$=0 (niveau bas B) et A$_1$=0 (niveau bas B), de manière que le courant I traverse les transistors T$_7$ et T$_{10}$. T$_0$ est sélectionné pour A$_0$=1 (niveau haut H) et A$_1$=1 (niveau haut H), pour A$_0$=0 et A$_1$=1, et T$_3$ pour A$_0$=1 et A$_1$=0.

La figure 6 représente une variante préférée du module multiplexeur de sortie 1 du multiplexeur à 16 voies de la figure 4. Il comporte les quatre transistors T$_0$ à T$_3$ recevant les signaux d'entrée E$_0$ à E$_3$, le transistor de sortie T$_4$ recevant sur sa base la tension de référence V$_{B1}$=−225 mV, et un circuit logique d'adressage comportant les mêmes éléments que dans la figure 5 et recevant les mêmes tensions de référence V$_{B2}$ et V$_{B3}$. Les collecteurs des transistors T$_0$ à T$_3$ ne sont pas connectés directement à la masse, mais sont connectés entre eux et sont reliés à la masse par une résistance R$_S$ de même valeur donc que celle disposée dans le collecteur du transistor T$_4$. Le collecteur des transistors T$_0$ à T$_3$ forme donc une sortie inverseuse sur laquelle le signal de sortie inversé $\overline{S}$ apparaît en même temps que le signal de sortie S. Ceci est rendu possible par le fait que le niveau haut H' des sorties des modules multiplexeurs 2 selon l'invention est légèrement en dessous du niveau 0 volt normalisé, soit une valeur d'environ −60 mV. Cet écart de niveau est suffisant pour qu'on puisse charger le collecteur des transistors T$_0$ à T$_3$ par la résistance R$_S$, sans risquer de saturer tout transistor recevant une entrée à un niveau haut.

La figure 7 représente une autre variante du module de sortie 1 du multiplexeur à 16 voies de la figure 4. Il comporte les quatre transistors T$_0$ à T$_3$ dont les collecteurs sont connectés à la masse et qui reçoivent sur leur base les signaux d'entrée E$_0$ à E$_3$, le transistor de sortie T$_4$ recevant sur sa base la tension de référence V$_{B1}$=−225 mV, et un circuit d'adressage comportant les mêmes éléments que dans la figure 6, à ceci près que la source de courant I est reliée à un circuit d'aiguillage autorisant une fonction mémoire remplie par un transistor d'auto-entretien T$_M$ de la sortie S du transistor T$_4$.

Un transistor T$_{13}$ reçoit sur sa base un signal de commande de mémorisation M. Son émetteur est relié à la base d'un transistor T$_{14}$ par l'intermédiaire de deux diodes en cascade D$_2$ et D$_3$ chargées par une source de courant I'$_M$. Le transistor T$_{14}$ est couplé par son émetteur à un transistor T$_{15}$ sont la base reçoit une tension de référence V$_{B4}$=V$_{B3}$−V$_{BE}$. La source de courant I est reliée aux émetteurs de T$_{14}$ et T$_{15}$. Le collecteur de T$_{14}$ est relié aux émetteurs de T$_9$ et T$_{10}$.

Le transistor d'auto-entretien T$_M$ a sa base connectée au collecteur du transistor de sortie T$_4$ délivrant le signal de sortie S, son collecteur connecté à la masse, et son émetteur couplé à un cinquième émetteur de T$_4$ ainsi qu'au collecteur de T$_{15}$.

Lorsque le signal de commande de mémorisation M est au niveau haut, $T_{14}$ est traversé par le courant I et le module de sortie fonctionne en multiplexeur. Lorsque le signal de commande de mémorisation M est à son niveau bas, le courant I traverse le transistor $T_{15}$ et le transistor $T_M$ maintient en l'état la sortie S (auto-entretien) quelque soient les signaux qui arrivent sur les entrées $E_0$ à $E_3$ (fonction mémoire). En effet, si S est au niveau haut, alors $T_M$, qui reçoit ce signal sur sa base est traversé par le courant I ce qui maintient S au niveau haut. Par contre, si S est au niveau bas, $T_4$ reste traversé par le courant I, car $T_M$ est bloqué par le signal S reçu sur sa base.

## Revendications

1. Module multiplexeur numérique à N entrées ($E_0 \ldots E_3$), chaque entrée qui est susceptible d'être portée à un niveau haut ou à un niveau bas, étant constituée par la base d'un transistor d'entrée d'un premier groupe ($T_0 \ldots T_3$) dont le collecteur est connecté à une première source de tension d'alimentation et dont l'émetteur est couplé à une électrode d'actionnement d'un premier élément semiconducteur de sortie ($T_4'$) présentant une pluralité d'électrodes d'actionnement ainsi qu'une électrode de sortie qui constitue la sortie du module (S') et qui est reliée à ladite première source de tension d'alimentation par l'intermédiaire d'une première résistance de sortie ($R_s'$) ledit module comportant également un premier circuit logique d'adressage (ALC) présentant une pluralité d'entrées ($A_0$, $A_1$) et destiné à adresser l'un ou l'autre des transistors d'entrée du premier groupe ($T_0 \ldots T_3$) en aiguillant une première source de courant référence (I) à une deuxième source de tension d'alimentation vers l'un ou l'autre des émetteurs des transistors d'entrée du premier groupe ($T_0 \ldots T_3$) fonction de l'adresse qu'il reçoit, caractérisé en ce que le premier élément semi-conducteur de sortie ($T'_4$) présente une pluralité de diodes dont une électrode est commune et constitue l'électrode de sortie, et dont l'autre électrode constitue chacun une des électrodes d'actionnement l'élément semi-conducteur de sortie ne présentant ainsi pas de tension de référence de sortie, et en ce que la première résistance de sortie ($R_s'$) à une valeur telle que, lorsque la base du transistor d'entrée adressé est au niveau bas, le courant de la première source de courant se répartisse de manière sensiblement égale entre l'émetteur dudit transistor d'entrée adressé et l'électrode d'actionnement qui est couplée.

2. Module multiplexeur selon la revendication 1 caractérisé en ce que le premier élément semi-conducteur de sortie est un premier transistor de sortie ($T'_4$) multi-émetteurs dont la base et le collecteur sont reliés et constituent l'électrode de sortie et dont les émetteurs constituent les électrodes d'actionnement.

3. Module multiplexeur selon une des revendications 1 ou 2 caractérisé en ce que N=$2^n$ et en ce que le premier circuit logique d'adressage (ALC), comporte n étages différentiels en cascade ($T_5 \ldots T_{10}$), le $k^{ième}$ étage présentant $2^{k-1}$ paires différentielles comportant chacune deux transistors à émetteurs couplés dont un reçoit sur sa base une $k^{ième}$ tension de référence d'adressage et dont l'autre reçoit sur sa base un niveau logique d'adresse de l'étage, les collecteurs des transistors des paires différentielles des (n−1) premiers étages étant reliés au point commun des émetteurs d'une paire différentielle de l'étage de rang immédiatement supérieur, et ceux des transistors du $n^{ième}$ étage étant reliés chacun à un émetteur d'un transistor d'entrée ($T_0 \ldots T_3$).

4. Multiplexeur numérique à $N^2$ entrées comportant N modules multiplexeurs d'entrée selon une des revendications précédentes et un module multiplexeur de sortie à N entrées dont chacune reçoit une sortie d'un des modules d'entrée, caractérisé en ce que le module multiplexeur de sortie est selon une des revendications 1 à 3.

5. Multiplexeur numérique à $N^2$ entrées comportant N modules multiplexeurs d'entrée selon une des revendications 1 à 3 et un module multiplexeur de sortie à N entrées dont chacun reçoit une sortie d'un des modules d'entrée caractérisé en ce que chaque entrée du module multiplexeur de sortie est constituée par la base d'un transistor d'entrée d'un deuxième groupe ($E_0 \ldots E_3$) dont le collecteur est relié à ladite source de tension d'alimentation et dont l'émetteur est couplé à un émetteur d'un deuxième transistor multi-émetteurs de sortie dont le collecteur est relié à ladite source de tension d'alimentation par l'intermédiaire d'une deuxième résistance de sortie ($R_s$), et dont la base reçoit une tension de référence ($V_{B1}$), ledit module de sortie comportant également un deuxième circuit logique d'adressage présentant une pluralité d'entrées et destiné à aiguiller une deuxième source de courant vers l'un ou l'autre des émetteurs des transistors d'entrée en fonction de l'adresse qu'il reçoit.

6. Multiplexeur numérique selon les revendications 3 et 5 prises ensemble et comportant donc $2^n$ entrées caractérisé en ce que le deuxième circuit d'adressage est du même type que le premier.

7. Multiplexeur numérique selon une des revendications 5 ou 6 caractérisé en ce que les première et deuxième sources de courant ont la même intensité (I) et en ce que la première résistance de sortie ($R'_s$) des modules multiplexeurs d'entrée a une valeur double de celle de la deuxième résistance de sortie ($R_s$) du module multiplexeur de sortie.

8. Multiplexeur numérique selon une des revendications 5 à 7 caractérisé en ce que, pour le module multiplexeur de sortie, les collecteurs des transistors d'entrée ($T_0 \ldots T_3$) du deuxième groupe sont connectés entre eux et reliés à la source de tension d'alimentation par l'intermédiaire d'une troisième résistance de sortie ($R_s^*$) de même valeur que la deuxième résistance de sortie de telle sorte que le signal présent sur les collecteurs des transistors d'entrée du deuxième groupe constitue une sortie logique inversée ($\overline{S}$) du multiplexeur.

9. Multiplexeur numérique selon une des revendications 5 à 7 caractérisé en ce qu'il comporte un circuit d'aiguillage commandé par un signal logique de mémorisation présentant un premier et un deuxième état et dirigeant la deuxième source de courant dans le premier état vers le deuxième circuit logique d'adressage (fonction multiplexage), et dans le deuxième état vers un transistor de mémorisation ($T_M$) dont l'émetteur est connecté à un $N+1^{ième}$ émetteur du deuxième transistor de sortie ($T_4$), dont la base est connectée au collecteur de ce dernier et dont le collecteur est connecté à ladite source de tension d'alimentation, le transistor de mémorisation ($T_M$) assurant dans le deuxième état un auto-entretien au niveau du collecteur du deuxième transistor de sortie ($T_4$) (fonction mémoire).

## Patentansprüche

1. Digitaler Multiplexermodul mit N Eingängen ($E_0 \ldots E_3$) wobei jeder Eingang, der sich zum Einstellen auf einen hohen Pegel oder auf einen niedrigen Pegel eignet, durch die Basis eines Eingangstransistors einer ersten Gruppe ($T_0 \ldots T_3$) dargestellt wird, dessen Kollektor mit einer ersten Speisespannungsquelle und dessen Emitter mit einer Betätigungselektrode eines ersten Halbleiter-Ausgangselements ($T_4'$) verbunden sind, das eine Anzahl von Betätigungselektroden sowie eine Ausgangselektrode enthält, die den Modulausgang ($S'$) darstellt und mit der ersten Speisespannungsquelle über einen ersten Ausgangswiderstand ($R_S'$) verbunden ist, wobei dieser Modul gleichfalls eine erste logische Adressierschaltung (ALC) besitzt, die eine Anzahl von Eingängen ($A_0, A_1$) enthält und zum Adressieren des einen oder des anderen der Eingangstransistoren der ersten Gruppe ($T_0 \ldots T_3$) dient, wobei eine auf eine zweite Speisespannungsquelle bezogene erste Stromquelle (I) mit einem oder dem anderen der Emitter der Eingangstransistoren der ersten Gruppe ($T_0 \ldots T_3$) in Abhängigkeit von der empfangenen Adresse gekoppelt wird, dadurch gekennzeichnet, daß das erste Halbleiter-Ausgangselement ($T_4'$) eine Anzahl von Dioden enthält, von denen eine Elektrode gemeinsam ist und die Ausgangselektrode darstellt und von denen die andere Elektrode je eine der Betätigungselektroden darstellt, wobei das Halbleiter-Ausgangselement dadurch nicht die Ausgangsbezugspannung liefert, und daß der erste Ausgangswiderstand ($R_S'$) einen derartigen Wert hat, daß die Basis des adressierten Eingangstransistors einen niedrigen Pegel führt, wobei der Strom der ersten Stromquelle sich im wesentlichen gleichermaßen zwischen dem Emitter des adressierten Eingangstransistors und der zugeschalteten Betätigungselektrode verteilt.

2. Multiplexermodul nach Anspruch 1, dadurch gekennzeichnet, daß das erste Halbleiter-Ausgangselement ein erster Ausgangstransistor ($T_4'$) mit mehreren Emittern ist, dessen Basis und dessen Kollektor miteinander verbunden sind und die Ausgangselektrode bilden, und dessen Emitter die Betätigungselektroden darstellen.

3. Multiplexermodul nach einem der Ansprüche 1 oder 2, dadurch gekennzeichnet, daß $N = 2^n$ ist, und daß die erste logische Adressierschaltung (ALC) n differenzielle, kaskadengeschaltete Stufen ($T_5 \ldots T_{10}$) enthält, wobei die k. Stufe $2^{k-1}$ differentielle Paare darstellt, die je zwei Transistoren besitzen, deren Emitter verbunden sind, wobei ein Transistor an seiner Basis eine k. Bezugsadressierspannung empfängt und der andere Transistor an seiner Basis einen logischen Adressierpegel der Stufe empfängt, wobei die Kollektoren der Transistoren der differenziellen Paare der $(n-1)$ ersten Stufen mit dem gemeinsamen Punkt der Emitter eines differenziellen Paares der Stufe mit nächsthöherem Rang verbunden sind, und die Kollektoren der Transistoren der n. Stufe mit je einem Emitter eines Eingangstransistors ($T_0 \ldots T_3$) verbunden sind.

4. Digitaler Multiplexer mit $N^2$ Eingängen mit N Eingangsmultiplexermodulen nach einem der vorangehenden Ansprüche und mit einem Ausgangsmultiplexerermodul mit N Eingängen, die je ein Ausgangssignal aus einem der Eingangsmoduln empfangen, dadurch gekennzeichnet, daß der Ausgangsmultiplexermodul nach einem der Ansprüche 1 bis 3 gekennzeichnet ist.

5. Digitaler Multiplexer mit $N^2$ Eingängen mit N Eingangsmultiplexermoduln nach einem der Ansprüche 1 bis 3 und mit einem Ausgangsmultiplexermodul mit N Eingängen, die je ein Ausgangssignal aus einem der Eingangsmoduln empfangen, dadurch gekennzeichnet, daß jeder Eingang des Ausgangsmultiplexermoduls durch die Basis eines Eingangstransistors einer zweiten Gruppe ($E_0 \ldots E_3$) dargestellt wird, dessen Kollektor mit der Speisespannungsquelle une dessen Emitter mit einem Emitter eines zweiten Transistors mit mehreren Ausgangsemittern verbunden sind, dessen Kollektor mit der Speisespannungsquelle über einen zweiten Ausgangswiderstand ($R_s$) verbunden ist, und dessen Basis eine Bezugsspannung ($V_{B1}$) empfängt, wobei der Ausgangsmodul gleichfalls eine zweite logische Adressierschaltung enthält, die eine Anzahl von Eingängen besitzt und zum Verbinden einer zweiten Stromquelle mit einem der dem anderen der Emitter der Eingangstransistoren in Abhängigkeit von der empfangenen Adresse enthält.

6. Digitaler Multiplexer nach Anspruch 3 und 5 in der Kombination und also mit $2^n$ Eingängen, dadurch gekennzeichnet, daß die zweite Adressierschaltung vom selben Typ wie die erste ist.

7. Digitaler Multiplexer nach einem der Ansprüche 5 oder 6, dadurch gekennzeichnet, daß die ersten und zweiten Stromquellen dieselbe Stromstärke (I) besitzen, und daß der erste Ausgangswiderstand ($R_s'$) der Eingangsmultiplexermoduln einen doppelten Wert im Vergleich zu dem des zweiten Ausgangswiderstands ($R_s$) des Ausgangsmultiplexermoduls besitzt.

8. Digitaler Multiplexer nach einem der Ansprüche 5 bis 7, dadurch gekennzeichnet, daß für den Ausgangsmultiplexermodul die Kollektoren der Eingangstransistoren ($T_0 \ldots T_3$) der zweiten Gruppe miteinander und mit der Speisespannungsquelle über einen dritten Ausgangswiderstand ($R_s$) mit dem gleichen Wert wie der des zweiten Ausgangstransistors derart verbunden sind, daß das Signal an den Kollektoren der Eingangstransistoren der zweiten Gruppe ein umgekehrtes logisches Ausgangssignal ($\overline{S}$) des Multiplexers darstellt.

9. Digitaler Multiplexer nach einem der Ansprüche 5 bis 7, dadurch gekennzeichnet, daß er eine Verbindungsschaltung enthält, die von einem logischen Speichersignal gesteuert wird, das einen ersten und einen zweiten Zustand darstellt und die zweite Stromquelle im ersten Zustand der zweiten logischen Adressierschaltung (multiplexfunktion) und im zweiten Zustand einem Speichertransistor ($T_M$) zuleitet, dessen Emitter mit einem N+1. Emitter des zweiten Ausgangstransistors ($T_4$), dessen Basis mit dem Kollektor des letztgenannten Transistors und dessen Kollektor mit der Speisespannungsquelle verbunden sind, wobei der Speichertransistor ($T_M$) im zweiten Zustand eine Selbsthaltung auf dem Pegel des Kollektors des zweiten Ausgangstransistors ($T_4$) (Speicherfunktion) gewährleistet.

**Claims**

1. A digital multiplexer module with N inputs ($E_0 \ldots E_3$), each of which can be connected to a high level or a low level and is formed by the base of an input transistor of a first group ($T_0 \ldots T_3$) whose collector is connected to a first supply voltage source and whose emitter is coupled to an active electrode of a first semiconductor output element ($T'_4$) which includes a plurality of active electrodes as well as one output electrode which constitutes the output (S') of the module and is connected to said first supply voltage source via a first output resistor ($R_s'$), which module also includes a first logic addressing circuit (ALC) which includes a plurality of inputs ($A_0$, $A_1$) and serves to address one of the input transistors of the first group ($T_0 \ldots T_3$) by connecting a first current source (I), referred to a second supply voltage source, to one of the emitters of the input transistors of the first group ($T_0 \ldots T_3$) as a function of the address it receives, characterized in that the first semiconductor output element ($T'_4$) includes a plurality of diodes having a common electrode which constitutes the output electrode, their other electrode each time forming one of the active electrodes, the semiconductor output element thus not involving an output reference voltage, and in that the first output resistor ($R_s'$) has a value such that when the base of the addressed input transistor is low, the current of the first current source is distributed substantially equally between the emitter of said addressed input transistor and the coupled active electrode.

2. A multiplexer module as claimed in Claim 1, characterized in that the first semiconductor output element is a multi-emitter output transistor ($T'_4$) whose base and collector are interconnected and constitute the output electrode, whilst its emitters constitute the active electrodes.

3. A multiplexer module as claimed in Claim 1 or 2, characterized in that $N=2^n$ and that the first logic addressing circuit (ALC) includes n cascade-connected differential stages ($T_5 \ldots T_{10}$), the $k^{th}$ stage having $2^{k-1}$ differential pairs, each of which includes two emitter-coupled transistors, one of which receives a $k^{th}$ reference addressing voltage on its base whilst the other transistor receives a logic stage address level on its base, the collectors of the transistors of the differential pairs of the (n−1) first stages being connected to the common junction of the emitters of a differential pair of the stage of directly higher rank, each of the collectors of the transistors of the $n^{th}$ stage being connected to an emitter of an input transistor ($T_0 \ldots T_3$).

4. A digital multiplexer which includes $N^2$ inputs and N input multiplexer modules as claimed in any one of the preceding Claims as well as an output multiplexer module which includes N inputs, each of which receives an output signal of one of the input modules, characterized in that the output multiplexer module is as claimed in any one of the Claims 1 to 3.

5. A digital multiplexer which includes $N^2$ inputs and N input multiplexer modules as claimed in any one of the Claims 1 to 3 as well as an output multiplexer module which includes N inputs, each of which receives an output signal of one of the input modules, characterized in that each input of the output multiplexer module is formed by the base of an input transitor of a second group ($E_0 \ldots E_3$) whose collector is connected to said supply voltage source and whose emitter is coupled to an emitter of a second multi-emitter output transistor whose collector is connected to said supply voltage source via a second output resistor ($R_s$) and whose base receives a reference voltage ($V_{B1}$), which output module also includes a second logic addressing circuit which has a plurality of inputs and which serves to connect a second current source to one of the emitters of the input transistors as a function of the address it receives.

6. A digital multiplexer as claimed in the Claims 3 and 5 combined, thus having $2^n$ inputs, characterized in that the second addressing circuit is of the same type as the first addressing circuit.

7. A digital multiplexer as claimed in Claim 5 or 6, characterized in that the first and second current sources have the same intensity (I), the first output resistor ($R'_s$) of the input multiplexer having a value which is twice as high as that of the second output resistor ($R_s$) of the output multiplexer module.

8. A digital multiplexer as claimed in any one of the Claims 5 to 7, characterized in that for the output multiplexer module the collectors of the input transistors ($T_0 \ldots T_3$) of the second group are connected to one another and to the supply voltage source via a third output resistor ($R_s$)

which has the same value as the second output resistor, so that the signal present on the collectors of the input transistors of the second group constitutes an inverted logic output signal $(\overline{S})$ of the multiplexer.

9. A digital multiplexer as claimed in any one of the Claims 5 to 7, characterized in that it includes a connection circuit which is controlled by a logic storage signal which has a first and second state and which connects the second current source to the second logic addressing circuit in the first state (multiplexing function) and in the second state to a storage transistor $(T_M)$ whose emitter is connected to an $N+1^{th}$ emitter of the second output transistor $(T_4)$, the base of said storage transistor being connected to the collector of said output transistor whilst its collector is connected to said supply voltage source, the storage transistor $(T_M)$ ensuring that in the second state the level of the collector of the second output transistor $(T_4)$ is maintained (storage function).

**FIG.1**

**FIG.2a**

**FIG.2b**

**FIG.3**

FIG.4

S,S'

$A_0 A_2$          $A_2 A_3$

$R'_S$

$E_0$   $E_1$   $E_2$   $E_3$          S'

$T_0$   $T_1$   $T_2$   $T_3$          $T'_4$

$A_0$   $T_{11}$

$A_1$   $T_{12}$

$D_1$

$T_5$      $T_6$ $V_{B2}$ $T_7$      $T_8$

$T_9$              $T_{10}$          $V_{B3}$

ALC

$I'_1$  $I'_0$          I

FIG.5

FIG.6

FIG.7